# EUROPÄISCHE PATENTSCHRIFT

(11) **EP 3 025 159 B1**
(45) Veröffentlichungstag und Bekanntmachung des Hinweises auf die Patenterteilung: **03.03.2021**
(21) Anmeldenummer: 15705475.0
(22) Anmeldetag: 19.01.2015
(51) Int. Cl.: G01R 1/073

(54) **VERTIKALNADELKARTE**
VERTICAL PROBE CARD
CARTE À POINTES VERTICALE

(30) Priorität: 20.01.2014 AT 362014
(43) Veröffentlichungstag der Anmeldung: 01.06.2016
(73) Patentinhaber: Gaggl, Rainer, 9580 Drobollach (AT)
(72) Erfinder: Gaggl, Rainer, 9580 Drobollach (AT)
(74) Vertreter: Beer & Partner Patentanwälte KG
(86) Internationale Anmeldenummer: PCT/AT2015/000006
(87) Internationale Veröffentlichungsnummer: WO 2015/106302

(56) Entgegenhaltungen:
- AT-A4- 511 058
- AT-B- 412 175
- AT-B1- 511 398
- DE-A1- 10 000 133
- US-A1- 2004 005 792

## Beschreibung

Die Erfindung betrifft eine Vertikalnadelkarte mit mehreren, Platten durchgreifenden und vorzugsweise gebogenen Prüfnadeln mit den Merkmalen des einleitenden Teils von Anspruch 1 (AT 511 398 B1).

Eine Vertikalnadelkarte der gattungsgemäßen Bauart ist aus der AT 511 398 B1 bekannt. Bei der aus der AT 511 398 B1 bekannten Nadelkarte sind die Nadeln, die wenigstens einmal ausgeknickt (ausgebogen) sind, zwischen den Platten durch wenigstens eine Isolierplatte geführt, wobei die Isolierplatte einen Rahmen aufweist, der an seinen einander gegenüberliegenden Seiten mit unidirektionalen Fasergelegen versehen ist. Die Fasergelege weisen elektrisch isolierende Fasern auf, die zueinander unter einem rechten Winkel ausgerichtet sind. Die Isolierplatte ist in der Nadelkarte in ihrer Ebene verschiebbar angeordnet.

In der Praxis kann vorgesehen sein, dass ein unidirektionales Fasergelege an der Oberseite des Rahmens der Isolierplatte und das andere unidirektionale Fasergelege, in dem die Fasern unter einem Winkel von 90° zu dem einen Fasergelege ausgerichtet sind, an der Unterseite des Rahmens der Isolierplatte angebracht sind.

Eine Vorrichtung zum Hochspannungsprüfen von Halbleiterbauelementen ist aus der AT 511 226 B1 (= WO 2012/122578 A1) bekannt.

Die aus AT 511 226 B1 bekannte Vorrichtung zum Vermeiden von Funkenüberschlägen beim Hochspannungsprüfen von Halbleiterbauelementen (Chips) auf Halbleiterscheiben umfasst eine auf die Halbleiterscheibe dichtend zustellbare Druckkammer mit einer Druckgaszuführung, sodass der Innenraum der Druckkammer unter Überdruck gesetzt werden kann und so die Zündspannung für einen Funkenüberschlag zwischen Kontaktflächen höher ist als die maximal anzulegende Prüfspannung. Die Druckkammer ist mit einer Nadelkarte mit Kontaktnadeln verbunden. Die Druckkammer besitzt einen beweglichen Teil, der relativ zu den mit der Nadelkarte verbundenen Teilen der Druckkammer beweglich ist. Der als Ringdichtung ausgebildete bewegliche Teil der Druckkammer wird durch ein Gaslager (Luftlager) im Spalt zwischen der Druckkammer und der Halbleiterscheibe dichtend im Abstand von der Oberfläche der Halbleiterscheibe gehalten, wobei zwischen dem mit der Nadelkarte verbundenen Teil der Druckkammer und dem beweglichen Teil der Druckkammer wenigstens eine Feder vorgesehen ist.

Aus der DE 100 00 133 A1 ist ein Prober für Drucksensoren bekannt. Dieser Prober umfasst einen Druckkopf, der einen einseitig offenen Innenraum aufweist und der mit seiner offenen Stirnseite derart auf den Drucksensor aufsetzbar ist, dass der Innenraum dicht verschlossen wird. Irgendwelche Maßnahmen, diesen Prober mit einer Vertikalnadelkarte, wie sie beispielsweise aus der AT 511 398 A1 bekannt ist, zu kombinieren, sind der DE 100 00 133 A1 nicht zu entnehmen.

Aus der US 2004/0005792 A1 ist eine elektrische Kontaktvorrichtung nach Art einer Vertikalnadelkarte mit S-förmig gebogenen Nadeln gezeigt und beschrieben. Die Nadeln sind in Löchern in wenigstens einer Platte verschiebbar aufgenommen und gebogen. Die aus der US 2004/0005792 A1 bekannte Kontaktvorrichtung soll für das Herstellen einer elektrisch leitenden Verbindung zwischen einem Prüfgerät und einem elektronischen Bauteil, wie einem Chip, verwendbar sein. Irgendwelche Hinweise, diese Nadelkarte mit einer Druckkammer zu kombinieren, sind aus der US 2004/0005792 A1 nicht zu entnehmen.

Aus der AT 511 058 A4 sind ein Verfahren und eine Vorrichtung zum Prüfen von Drucksensoren, insbesondere Drucksensorchips eines Halbleiterbauelementes, bekannt. Die AT 511 058 A4 offenbart eine Nadelkarte der Bauart Cantilever-Nadelkarte. Bei der aus der AT 511 058 A4 bekannten Vorrichtung zum elektrischen und pneumatischen Prüfen von Drucksensoren, insbesondere Drucksensorchips, in einer Halbleiterscheibe wird die Halbleiterscheibe elektrisch kontaktiert und in einer Druckkammer unter einen definierten Überdruck gesetzt. Der die Halbleiterscheibe belastende Überdruck wird durch einen Referenzdrucksensor erfasst. Die Druckkammer ist an einer Nadelkarte mit Prüfnadeln angeordnet und weist einen Teil auf, der relativ zur Nadelkarte bewegt werden kann. Zwischen der der Halbleiterscheibe zugekehrten Stirnfläche des beweglichen Teils der Druckkammer und der Halbleiterscheibe wird ein Gaslager (Luftlager) ausgebildet. Die aus der AT 511 058 A4 bekannte Vorrichtung erlaubt es, Drucksensorchips in einer Halbleiterscheibe unter definierten Bedingungen zu prüfen, wobei das Prüfen nicht nur bei einem definierten Druck, sondern auch bei im akustischen Bereich liegenden Druckschwankungen möglich ist.

Eine Vertikalnadelkarte, wie sie beispielsweise aus der AT 511 398 B1 bekannt ist, mit einer Druckkammer entsprechend der AT 511 226 B1 (= WO 2012/122578 A1) zu kombinieren, ist nicht ohne Weiteres durchführbar, wenn einerseits die Funktion der über das Halbleiterbauelement, das zu prüfen ist, gestülpten Druckkammer und anderseits die Funktion der Vertikalnadelkarte (Vertikalprüfkarte) erhalten bleiben soll. Damit die vorteilhaften Effekte sowohl der Vertikalnadelkarte als auch der Druckkammer erhalten bleiben, sind über eine einfache Kombination hinaus weitere Maßnahmen erforderlich.

Der Erfindung liegt die Aufgabe zugrunde, die aus AT 511 398 B1 bekannte Vertikalnadelkarte derart weiterzubilden, dass sie auch zum Hochspannungsprüfen von Halbleiterbauelementen (Halbleiterscheiben) und zum Prüfen von Drucksensoren in Halbleiterbauelementen, insbesondere Drucksensorchips eines Halbleiterbauelementes, verwendet werden kann.

Gelöst wird diese Aufgabe erfindungsgemäß mit einer Vertikalnadelkarte, welche die Merkmale von Anspruch 1 aufweist. Bevorzugte und vorteilhafte weitere Ausgestaltungen der erfindungsgemäßen Vertikalnadelkarte sind Gegenstand der Unteransprüche.

Da bei der erfindungsgemäßen Vertikalnadelkarte jetzt eine Druckkammer vorgesehen ist, kann diese unter Beibehalten der Vorteile der Nadelkarte aus AT 511 398 B1 auch für das Hochspannungsprüfen von Halbleiterbauelementen verwendet werden, wobei Funkenüberschläge beim Hochspannungsprüfen vermieden sind.

In gleicher Weise kann die erfindungsgemäße Vertikalnadelkarte unter Beibehalten der Vorteile der Vertikalnadelkarte gemäß der AT 511 398 B1 auch zum Prüfen von Drucksensoren, insbesondere Drucksensorchips, in Halbleiterbauelementen verwendet werden.

Bei der Erfindung ist es vorteilhaft, dass die über das zu prüfende Haltleiterbauelement (Chip) gestülpte Druckkammer ohne (erhebliche) Änderungen der Vertikalnadelkarte so dimensioniert sein kann, dass sie nicht wesentlich größer ist als das zu prüfende (zu messende) Halbleiterbauelement, insbesondere der zu messende Chip bzw. die zu messenden Chips in einer Anwendung zum Mehrfachmessen.

Wenn die Druckkammern, die grundsätzlich aus der AT 511 226 B1 oder der WO 2012/122578 A1 bekannt sind, erheblich größere Abmessungen aufweisen als das zu messende Halbleiterbauelement (z.B. Chipanordnung), steht beim Kontaktieren von Chips, die in der Nähe des Randes des Halbleiterbauelementes (Wafer) liegen, ein Teil der beweglichen Dichtung der Druckkammer über den Rand des Halbleiterbauelementes über. Dadurch ist ein zuverlässiges Abdichten der Druckkammer nicht mehr gewährleistet. Ein Druck über am Rand des Halbleiterbauelementes liegenden Chips kann dann nicht mehr aufgebaut werden. Mit der Erfindung ist es gelungen, die Druckkammer so zu gestalten, dass der zu messende-Chip bzw. die zu messenden Chips von der beweglichen Dichtung möglichst knapp umschlossen werden.

Bei der Erfindung wird erreicht, dass einzelne Komponenten der Vertikalnadelkarte (Vertikalprüfkopf) die Funktion der Druckkammer und der Dichtung übernehmen. Eine Anforderung, die bei einer Vertikalnadelkarte, wie sie aus der AT 511 398 B1 bekannt ist, nicht besteht.

Weitere Einzelheiten, Merkmale und Vorteile der erfindungsgemäßen Vertikalnadelkarte ergeben sich aus der nachstehenden Beschreibung der in der Zeichnung im Schnitt links gezeigten Ausführungsform.

Eine in der Figur links gezeigte Ausführungsform einer Vorrichtung ("Vertikalnadelkarte") zum Prüfen von Halbleiterbauelementen 5 umfasst eine Nadelkarte 1 (Leiterplatte), an der Kontaktnadeln 4, die gewinkelt und wenigstens einmal ausgeknickt (ausgebogen) ausgebildet sind, angebracht sind. An der Nadelkarte 1 ist ein Gehäuse 8 angeordnet, das einen flanschartigen Teil 9 und einen zylindermantelförmigen Teil 10 umfasst. Der zylindermantelförmige Teil 10 des Gehäuses 8 umgrenzt eine Druckkammer 11.

Zwischen dem flanschartigen Teil 9 des Gehäuses 8 und der Nadelkarte 1 ist eine Führung 3 (Platte, beispielsweise aus Keramikwerkstoff) für die Nadeln 4 vorgesehen. Eine weitere Führung 3 (Platte, beispielsweise aus Keramikwerkstoff) für die freien Enden der Nadeln 4 der Nadelkarte 1, also den Enden, die dem elektrisch zu prüfenden Halbleiterbauelement 5 zugeordnet sind und an dieses angelegt werden, ist im Bereich des offenen Endes der Druckkammer 11, also an dem freien Rand des zylindermantelförmigen Teils 10, der vom flanschartigen Teil 9 des Gehäuses 8 abgekehrt ist, vorgesehen. Zwischen den als Führungen 3 für die Nadeln 4 dienenden Platten kann (nicht gezeigt) ein unidirektionales Fasergelege oder ein Vlies (nonwoven) als Isolierplatte vorgesehen sein. Eine elektrische Isolierung der in der Druckkammer 11 liegenden Teile der Nadeln 4 kann auch durch eine isolierende Beschichtung der Nadeln 4 wenigstens in ihren im Prüfkopf liegenden Bereichen, erfolgen. So sind die Nadeln 4 (auch ohne Isolierplatte) voneinander elektrisch isoliert.

In der Nadelkarte 1 sind Kanäle 2 ausgespart, die für das Zuführen von Druckgas (Druckluft) in die Druckkammer 11 bestimmt sind. Durch das zugeführte Druckgas wird in der vom zylindermantelförmigen Teil 10 des Gehäuses 8 umgrenzten Druckkammer 11 Überdruck aufgebaut, sodass entweder eine Hochspannungsprüfung von Halbleiterbauelementen 5 oder eine elektrische und pneumatische Prüfung von Drucksensoren (Drucksensorchips) in Halbleiterbauelementen 5 ausgeführt werden kann.

Der zylindermantelförmige Teil 10 des Gehäuses 8, der die Druckkammer 11 umgrenzt, ist in der in der Figur rechts dargestellten Ausführungsform von einem relativ zur Nadelkarte 1 axial, also quer zur Nadelkarte 1, beweglichen Dichtring 7 umgeben.

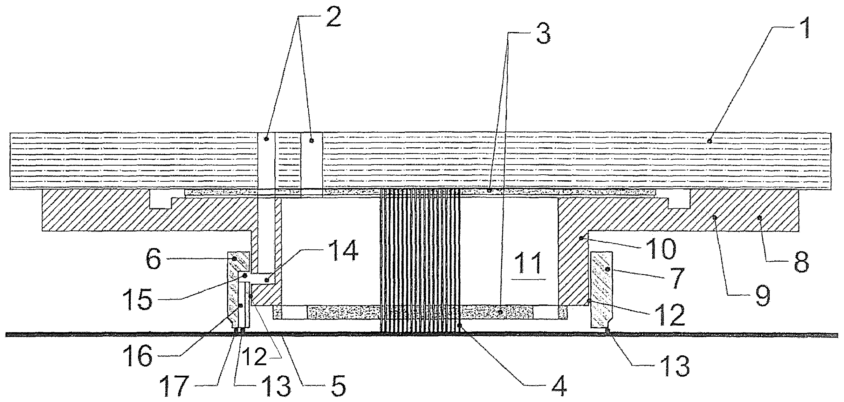

Der Dichtring 7 ist im in Fig. 1 rechts dargestellten Ausführungsbeispiel über ein statisches Gaslager (Luftlager) 12 an der Außenseite des zylindermantelförmigen Teils 10 des Gehäuses 8 geführt.

Bei der in der Figur rechts dargestellten Ausführungsform wird das für das Gaslager (Luftlager) 12 benötigte Druckgas (Druckluft) über die Druckkammer 11 zugeführt. Im Einzelnen ist diese Ausführungsform wie folgt ausgebildet:
Zwischen dem Halbleiterbauelement 5 und dem Dichtring 7 strömt Druckgas (Druckluft) durch einen dort vorgesehenen Spalt 13 aus der Druckkammer 11 ab. Daher bildet sich bei der erfindungsgemäßen Vorrichtung im Spalt 13 zwischen dem Dichtring 7, also dem beweglichen Teil der Druckkammer 11, und dem Halbleiterbauelement 5 ein Gaslager (Luftlager) aus. Da Druckluft aus der Druckkammer 11 durch den Spalt 13 zwischen dem Dichtring 7 und der Oberseite des Halbleiterbauelementes 5 austritt, wird der Dichtring 7 auf Grund des im Spalt 13 auftretenden Bernoulli-Effektes dichtend, aber im Abstand von der Oberseite des Halbleiterbauelementes 5 gehalten.

Bei der in der Zeichnung links dargestellten Ausführungsform ist das im Spalt zwischen der Außenseite des zylindermantelförmigen Teils 10 des Gehäuses 8 und dem Dichtring 6 gebildete Gaslager (Luftlager) 12 nicht über die Druckkammer 11, sondern über einen der Kanäle 2 mit Druckgas (Druckluft) beaufschlagt. Im Einzelnen ist hierzu an der Außenseite des zylindermantelförmigen Teils 10 des Gehäuses 8 ein ringförmiger, radial nach außen offener Kanal 14 vorgesehen, in den der Kanal 2 mündet. Der Kanal 14 liegt einem ringförmigen, nach innen offenen Kanal 15 an der Innenseite des Dichtringes 6 gegenüber. Von dem ringförmigen Kanal 15 im Dichtring 6 führen mehrere Leitungen (Kanäle) 16 weg, die in der dem Halbleiterbauelement 5 zugekehrten, ringförmigen Endfläche 17 des Dichtringes 6, also in den dort vorliegenden Spalt 13 zwischen Dichtring 6 und Halbleiterbauelement 5, münden.

Dem ringförmigen Kanal 14, der in dem zylindermantelförmigen Teil 10 des Gehäuses 8 vorgesehen ist, kann in einer abgeänderten Ausführungsform Druckgas (Druckluft) über nicht gezeigte Leitungen aus dem Innenraum der Druckkammer 11 zugeführt werden.

Der Dichtring 7 steht in seiner Wirkstellung über den zylinderförmigen Teil 10 vor, sodass die Stirnfläche 17 derselben vom Halbleiterbauelement 5 einen kleineren Abstand hat als das Gehäuse 8.

Wenn die erfindungsgemäße Vorrichtung zum Hochspannungsprüfen von Halbleiterbauelementen verwendet wird, erfolgt das Überwachen des Druckes in der Druckkammer 11 mit Hilfe eines Drucksensors oder eines Druckschalters (nicht gezeigt), sodass sichergestellt ist, dass der Solldruck in der Druckkammer 11 vor Beginn der Hochspannungsprüfung tatsächlich aufgebaut ist. Der Drucksensor oder der Druckschalter kann dem Innenraum der Druckkammer 11 unmittelbar zugeordnet sein. Es ist aber auch möglich, dass der Drucksensor oder der Druckschalter über eine Leitung mit dem Innenraum der Druckkammer 11 verbunden ist. Der Drucksensor oder ein sinngemäß wirkender Druckschalter kann aber auch in der Leitung zum Zuführen von Druckgas (Druckluft) vorgesehen sein. Wesentlich ist bloß, dass der Drucksensor oder der Druckschalter den Druck im Innenraum der Druckkammer 11 erfasst und das Anlegen der Prüfspannung erst erlaubt, wenn der vorgegebene Mindestdruck, der hinreicht, bei der Prüfspannung Funkenüberschläge zu verhindern, erreicht ist.

Wenn die erfindungsgemäße Vorrichtung zum Prüfen von Drucksensoren in Halbleiterbauelementen 5 verwendet wird, ist der Druckkammer 11 ein Referenzdrucksensor (nicht gezeigt) zugeordnet. Durch den Referenzdrucksensor kann der im Innenraum der Druckkammer 11 herrschende Überdruck erfasst werden. Der Referenzdrucksensor kann mit dem Innenraum der Druckkammer 11 über einen Anschluss in Verbindung stehen oder aber der Referenzdrucksensor ist unmittelbar im Innenraum der Druckkammer 11 angeordnet, sodass eine gesonderte Anschlussleitung für den Referenzdrucksensor entfallen kann.

Zusammenfassend kann ein Ausführungsbeispiel der Erfindung wie folgt beschrieben werden:
An einer Vertikalnadelkarte 1 ist ein Gehäuse 8 mit einer Druckkammer 11, die von einem zylindermantelförmigen Teil 10 des Gehäuses 8 gebildet ist, vorgesehen. Außerhalb der Druckkammer 11 ist ein axial beweglicher Dichtring 6 vorgesehen. Der Dichtring 6 wird auf Grund des Bernoulli-Effektes, der durch Druckgas, das aus im Dichtring 6 vorgesehenen Kanälen 16 in den Spalt 13 zwischen Dichtring 6 und Halbleiterbauelement 5 strömt, entsteht, in definiertem Abstand vom Halbleiterbauelement 5 gehalten.

## Patentansprüche

1. Vertikalnadelkarte (1) mit mehreren Platten (3) durchgreifenden Prüfnadeln (4), wobei sich die Nadeln (4) zwischen den Platten (3) gegebenenfalls durch eine Isolierplatte erstrecken, **dadurch gekennzeichnet, dass** der Vertikalnadelkarte (1) eine Druckkammer (11) zugeordnet ist, die über eine Druckgasleitung (2) unter Überdruck gesetzt werden kann, dass die Druckkammer (11) zu dem zu prüfenden Halbleiterbauelement (5) hin offen ist, dass der Druckkammer (11) ein beweglicher Dichtring (6) zugeordnet ist, der senkrecht zur Ebene der Nadelkarte (1) bzw. des zu prüfenden Halbleiterbauelementes (5) beweglich ist, dass die Druckkammer (11) von einem zylindermantelförmigen Teil (10) eines Gehäuses (8) gebildet ist, dass das Gehäuse (8) zusätzlich zu dem zylindermantelförmigen Teil (10) einen flanschartigen Teil (9) aufweist, der an der Nadelkarte (1) anliegt, dass der Dichtring (6, 7) an der Außenseite der Druckkammer (11) über ein statisches Gaslager (12) geführt ist, und dass dem Gaslager (12) zwischen der Außenseite des zylindermantelförmigen Teils (10) des Gehäuses (8) und der Innenseite des Dichtringes (6) Druckgas über einen ringförmigen, radial nach außen offenen Kanal (14) im zylindermantelförmigen Teil (10) des Gehäuses (8) zugeführt wird.

2. Vertikalnadelkarte nach Anspruch 1, **dadurch gekennzeichnet, dass** der Druckkammer (11) eine Einrichtung zum Überwachen des Druckes im Innenraum der Druckkammer (11) zugeordnet ist.

3. Vertikalnadelkarte nach Anspruch 2, **dadurch gekennzeichnet, dass** die Einrichtung ein Druckschalter oder ein Drucksensor ist.

4. Vertikalnadelkarte nach Anspruch 2, **dadurch gekennzeichnet, dass** die Einrichtung ein Referenzdrucksensor ist.

5. Vertikalnadelkarte nach einem der Ansprüche 1 bis 4, **dadurch gekennzeichnet, dass** dem Spalt (13) zwischen der dem Halbleiterbauelement (5) zugekehrten Stirnfläche (17) des Dichtringes (6) und dem Halbleiterbauelement (5) Druckgas durch im Dichtring (6) vorgesehene Kanäle (16) zugeführt wird.

6. Vertikalnadelkarte nach einem der Ansprüche 1 bis 5, **dadurch gekennzeichnet, dass** die der Nadelkarte (1) benachbarte, von Nadeln (4) durchgriffene Platte (3) zwischen der Nadelkarte (1) und dem flanschartigen Teil (9) des Gehäuses (8) angeordnet ist.

7. Vertikalnadelkarte nach einem der Ansprüche 1 bis 6, **dadurch gekennzeichnet, dass** die von der Vertikalnadelkarte (1) beabstandete Platte (3) am freien Ende des zylindermantelförmigen Teils (10) des Gehäuses (8) angeordnet ist.

8. Vertikalnadelkarte nach einem der Ansprüche 1 bis 7, **dadurch gekennzeichnet, dass** die Stirnfläche (17) des Dichtringes (6) in der Wirkstellung des Dichtringes (6) über die am freien Ende des zylindermantelförmigen Teils (10) des Gehäuses (8) vorgesehene Endfläche oder die dort vorgesehene Platte (3) übersteht.

9. Vertikalnadelkarte nach einem der Ansprüche 1 bis 8, **dadurch gekennzeichnet, dass** dem radial nach außen offenen Kanal (14) Druckgas durch im zylindermantelförmigen Teil (10) des Gehäuses (8) vorgesehene Kanäle (16) zugeführt wird.

## Claims

1. Vertical probe card (1) comprising a plurality of test probes (4) which pass through plates (3), wherein the probes (4) optionally extend through an insulating plate between the plates (3), **characterized in that** the vertical probe card (1) is assigned a pressure chamber (11) which can be placed under positive pressure by way of a compressed gas line (2), **in that** the pressure chamber (11) is open towards the semiconductor component (5) to be tested, **in that** the pressure chamber (11) is assigned a movable sealing ring (6) which is movable perpendicular to the plane of the probe card (1) and of the semiconductor component (5) to be tested, **in that** the pressure chamber (11) is formed by a cylinder-shell-shaped part (10) of a housing (8), **in that** the housing (8) has, in addition to the cylinder-shell-shaped part (10), a flange-like part (9) which bears against the probe card (1), **in that** the sealing ring (6, 7) is guided on the outer side of the pressure chamber (11) by way of a static gas bearing (12), and **in that** compressed gas is fed to the gas bearing (12) between the outer side of the cylinder-shell-shaped part (10) of the housing (8) and the inner side of the sealing ring (6) by way of an annular, radially outwardly open channel (14) in the cylinder-shell-shaped part (10) of the housing (8).

2. Vertical probe card according to claim 1, **characterized in that** the pressure chamber (11) is assigned a device for monitoring the pressure in the interior of the pressure chamber (11).

3. Vertical probe card according to claim 2, **characterized in that** the device is a pressure switch or a pressure sensor.

4. Vertical probe card according to claim 2, **characterized in that** the device is a reference pressure sensor.

5. Vertical probe card according to any one of claims 1 to 4, **characterized in that** compressed gas is fed to the gap (13) between the end face (17) of the sealing ring (6) that faces toward the semiconductor component (5) and the semiconductor component (5) through channels (16) provided in the sealing ring (6).

6. Vertical probe card according to any one of claims 1 to 5, **characterized in that** the plate (3) which is adjacent to the probe card (1) and through which probes (4) pass is arranged between the probe card (1) and the flange-like part (9) of the housing (8).

7. Vertical probe card according to any one of claims 1 to 6, **characterized in that** the plate (3) which is at a distance from the vertical probe card (1) is arranged at the free end of the cylinder-shell-shaped part (10) of the housing (8).

8. Vertical probe card according to any one of claims 1 to 7, **characterized in that** the end face (17) of the sealing ring (6) in the operative position of the sealing ring (6,) protrudes beyond the end face provided at the free end of the cylinder-shell-shaped part (10) of the housing (8) or beyond the plate (3) provided there.

9. Vertical probe card according to any one of claims 1 to 8, **characterized in that** compressed gas is fed to the radially outwardly open channel (14) through channels (16) provided in the cylinder-shell-shaped part (10) of the housing (8).

## Revendications

1. Carte à pointes verticale (1) avec des pointes de test (4) traversant plusieurs plaques (3), dans laquelle les pointes (4) s'étendent entre les plaques (3) en traversant éventuellement une plaque isolante, **caractérisée en ce que** la carte à pointes verticale (1) est associée à une chambre sous pression (11) dans laquelle une surpression peut être créée à l'aide d'une conduite de gaz sous pression (2), **en ce que** la chambre sous pression (11) est ouverte vers le composant semi-conducteur (5) à tester, **en ce que** la chambre sous pression (11) est associée à un joint d'étanchéité mobile (6) qui est mobile perpendiculairement au plan de la carte à pointes (1) ou du composant semi-conducteur (5) à tester, **en ce que** la chambre sous pression (11) est formée par une partie en forme d'enveloppe cylindrique (10) d'un boîtier (8), **en ce que** le boîtier (8) comporte, outre la partie en forme d'enveloppe cylindrique (10), une partie en forme de bride (9) qui repose sur la carte à pointes (1), **en ce que** le joint d'étanchéité (6, 7) est guidé sur l'extérieur de la chambre sous pression (11) par un coussinet de gaz statique (12) et **en ce que** du gaz comprimé est amené au coussinet de gaz (12) entre la face extérieure de la partie en forme d'enveloppe cylindrique (10) du boîtier (8) et la face intérieure du joint d'étanchéité (6) par un canal (14) annulaire ouvert vers l'extérieur dans le sens radial dans la partie en forme d'enveloppe cylindrique (10) du boîtier (8).

2. Carte à pointes verticale selon la revendication 1, **caractérisée en ce que** la chambre sous pression (11) est associée à un dispositif pour la surveillance de la pression à l'intérieur de la chambre sous pression (11).

3. Carte à pointes verticale selon la revendication 2, **caractérisée en ce que** le dispositif est un manocontacteur ou un capteur de pression.

4. Carte à pointes verticale selon la revendication 2, **caractérisée en ce que** le dispositif est un capteur de pression de référence.

5. Carte à pointes verticale selon l'une des revendications 1 à 4, **caractérisée en ce que** du gaz comprimé est amené dans l'interstice (13) entre la face frontale (17) du joint d'étanchéité (6) tournée vers le composant semi-conducteur (5) et le composant semi-conducteur (5) à travers des canaux (16) prévus dans le joint d'étanchéité (6) .

6. Carte à pointes verticale selon l'une des revendications 1 à 5, **caractérisée en ce que** la plaque (3) voisine de la carte à pointes (1) et traversée par les pointes (4) est disposée entre la carte à pointes (1) et la partie en forme de bride (9) du boîtier (8).

7. Carte à pointes verticale selon l'une des revendications 1 à 6, **caractérisée en ce que** la plaque (3) écartée de la carte à pointes verticale (1) est disposée sur l'extrémité libre de la partie en forme d'enveloppe cylindrique (10) du boîtier (8).

8. Carte à pointes verticale selon l'une des revendications 1 à 7, **caractérisée en ce que** la face frontale (17) du joint d'étanchéité (6) dépasse, dans la position angulaire du joint d'étanchéité (6), au-delà de la surface d'extrémité prévue à l'extrémité libre de la partie en forme d'enveloppe cylindrique (10) du boîtier (8) ou de la plaque (3) prévue à cet endroit.

9. Carte à pointes verticale selon l'une des revendications 1 à 8, **caractérisée en ce que** du gaz comprimé est amené au canal (14) ouvert vers l'extérieur dans le sens radial à travers des canaux (16) prévus dans la partie en forme d'enveloppe cylindrique (10) du boîtier (8).
